# FASCICULE DE BREVET EUROPEEN

(11) **EP 0 895 828 B1**
(45) Date de publication et mention de la délivrance du brevet: **08.01.2003**
(21) Numéro de dépôt: 98420138.4
(22) Date de dépôt: 31.07.1998
(51) Int. Cl.: B23P 11/00, B21J 15/02, A47J 27/21, F16B 5/04, B21D 39/03

(54) **Dispositif de fixation de pièces d'un appareil électroménager**
Vorrichtung zur Befestigung von Teilen eines elektrischen Haushaltgerätes
Device for fastening pieces of an electrical household appliance

(30) Priorité: 04.08.1997 FR 9710172
(43) Date de publication de la demande: 10.02.1999
(73) Titulaire: SEB S.A., 69130 Ecully (FR)
(72) Inventeur: Balandier, Jean-Marie, 88400 Gérardmer (FR); Remy, Bernard, 88120 Vagney (FR); Joannes, Daniel, 88290 Thiefosse (FR); Klinger, Michel, 68140 Stosswihr (FR)
(74) Mandataire: Kiehl, Hubert

(56) Documents cités:
- EP-A- 0 636 332
- FR-A- 2 593 837
- GB-A- 740 933
- GB-A- 2 180 030

## Description

La présente invention est relative à un dispositif de fixation de pièces d'un appareil électroménager, dont l'une au moins est une pièce d'assemblage métallique en forme de tôle ou de plaque comprenant un élément d'assemblage et de sertissage faisant saillie de l'une des faces de ladite pièce d'assemblage métallique et dont la structure est issue de ladite pièce.

Le problème à résoudre est celui de l'assemblage robuste et économique notamment d'un organe (régulateur ou autre pièce) sur une pièce de fixation, qui peut être en particulier une pièce intermédiaire se trouvant en contact étroit par brasage ou collage, avec une pièce constituant une paroi d'un appareil électroménager. Aucune marque de rivetage ne doit apparaître sur cette paroi qui doit rester étanche. Une telle paroi peut notamment être celle d'une cuve de bouilloire électrique ou de cafetière, de cuve de friteuse, de générateur de vapeur pour fer à repasser ou nettoyeur de surface, de cuiseur à eau ou à vapeur, etc...

La présente invention trouve donc particulièrement son application dans le chauffage alimentaire où la pièce intermédiaire est une tôle d'aluminium en contact avec une tôle d'acier inoxydable. La tôle d'aluminium doit répartir les calories dissipées par une résistance vers la tôle d'acier inoxydable, de plus grande surface, au contact de l'aliment. L'acier inoxydable, ou un autre matériau ayant des propriétés semblables, est choisi pour son innocuité au regard des aliments en contact, pour sa résistance à la corrosion et à l'entartrage, pour sa robustesse aux agressions mécanique et chimique, et pour son esthétique. Il pourrait être choisi également un acier revêtu d'un polymère alimentaire (PTFE par exemple) ou de tout dépôt chimique ou électrolytique (or, nickel...).

On a déjà proposé des dispositifs de fixation de ce type dans lesquels des rivets sont obtenus par déformation de l'une des tôles à assembler elle-même. A cet effet, on forme une saillie à la surface de la tôle soit par fluage d'une portion de cette tôle dans une matrice présentant en négatif la forme de la cheville destinée à constituer le rivet, soit par semi-poinçonnage de la tôle, soit encore par étirage localisé de la tôle dans une empreinte à l'aide d'un poinçon dont le diamètre est plus petit que celui de l'empreinte.

Pour fixer une pièce à l'aide d'un tel dispositif, il y a lieu d'introduire la partie saillante du rivet dans une ouverture de la pièce à fixer, dont la longueur axiale de l'ouverture est évidemment inférieure à la longueur de cette partie saillante, puis de river ou de sertir, c'est-à-dire de déformer la partie du rivet sortant de l'ouverture de la pièce à fixer autour de cette ouverture pour maintenir les deux pièces assemblées.

La base de tels rivets intégrés se situe forcément en retrait par rapport au niveau de la surface d'appui de la pièce dans laquelle ce rivet est formé, la surface d'appui de cette pièce correspondant à la face opposée à celle de laquelle le rivet fait saillie. Il n'est donc pas possible d'exercer sur l'extrémité libre de ce rivet la pression nécessaire à son sertissage, sans venir en appui contre la base en retrait de ce rivet, faute de quoi, la matière du rivet serait au moins en partie refoulée dans la pièce à laquelle ce rivet est intégré au lieu d'être sertie autour de l'ouverture de la pièce à fixer, ne permettant pas d'obtenir une fixation avec la résistance souhaitée à l'arrachage. Ce risque de refoulement de la matière du rivet est d'autant plus grand que la matière dans laquelle est fait le rivet est en un matériau malléable, tel que l'aluminium ou le cuivre notamment.

Il existe des applications dans lesquelles soit il n'est pas possible d'accéder à la base en retrait du rivet intégré, soit il est nécessaire que la surface d'appui de la pièce dans laquelle le rivet intégré est formé ne soit pas abîmée par la formation d'un rivet intégré du type susmentionné. Il existe par ailleurs également des applications, dans lesquelles, faute de place au-dessus du rivet, il n'est pas possible d'utiliser une bouterolle de sertissage animée d'un mouvement oscillant, ou une bouterolle dont le diamètre excède le diamètre du rivet de plus d'environ 1 mm. Par conséquent la tête du rivet ne peut être obtenue que par un mouvement de pressage rectiligne et une bouterolle plane ou légèrement conique. Or, la force d'arrachement de la fixation est donnée par le volume de la tête du rivet, d'où l'importance que celui-ci ne puisse pas reculer sous l'effet de la pression de la bouterolle, puisque dans ce cas, son volume en serait diminué d'autant au détriment de la résistance de la fixation à l'arrachage.

Un autre facteur est encore à prendre en compte. Etant données les tolérances de fabrication et le fait que, en général, plusieurs rivets sont nécessaires pour fixer ensemble deux pièces, il est nécessaire de prévoir un diamètre de rivet sensiblement plus petit que celui de l'ouverture engagée sur ce rivet. Par conséquent, lors du sertissage, le volume du rivet doit permettre de combler le jeu entre le rivet et l'ouverture et former une tête de rivet d'un volume suffisant. Si la section du rivet est plus petite que celle de l'ouverture engagée sur lui, son volume est donc réduit, de sorte que pour compenser cette réduction de volume, il y a lieu d'augmenter la longueur du rivet. Ceci est d'autant plus difficile à réaliser que la tôle de base dans laquelle le rivet est formé est mince.

On a déjà proposé dans le FR-2 581 571 un procédé de fermeture d'une chambre de vaporisation d'un fer à repasser à vapeur selon lequel le couvercle de fermeture de cette chambre est pressé sur le corps de la semelle de repassage avec une pression suffisante pour faire fluer la matière du couvercle dans des logements ménagés dans la semelle. Etant donné que la section de ces logements est trapézoïdale, ce couvercle est fixé à demeure et de façon étanche à la semelle de repassage. Cette fixation n'est pas un rivetage et n'est pas utilisable dans le mode d'assemblage qui intéresse la présente invention. Elle ne montre qu'un mode de fixation obtenu par fluage de la pièce à fixer dans un logement de l'autre pièce à fixer.

Le but de la présente invention est de remédier, au moins en partie, aux inconvénients susmentionnés, de manière à permettre une fixation par rivet intégré permettant d'effectuer le sertissage du ou des rivets à l'aide d'une surface d'appui sans partie en relief.

Ce but est réalisé par un dispositif de fixation du type susmentionné dans lequel la partie de la pièce d'assemblage métallique formant la base dudit élément d'assemblage et de sertissage s'étend jusqu'au niveau de l'autre face de la pièce d'assemblage métallique, le volume de la partie saillante dudit élément d'assemblage et de sertissage correspondant sensiblement à celui d'un déplacement de matière, obtenu par réduction locale de l'épaisseur autour de la base et autour du côté de l'élément d'assemblage et de sertissage.

Contrairement aux rivets intégrés de l'art antérieur, la base du rivet selon la présente invention se situe au même niveau que la face inférieure de la tôle ou de la plaque, la partie saillante de ce rivet étant formée par fluage de la matière environnante de cette tôle ou de cette plaque. Comme on le verra, la longueur de cette partie saillante du rivet peut correspondre à plusieurs fois l'épaisseur de la tôle ou de la plaque à partir de laquelle la partie saillante de ce rivet est formée. Lors du sertissage à l'aide de ce rivet, sa base se trouvant au niveau du revers de la tôle par rapport à la partie saillante du rivet, il suffit de venir en appui contre une surface plate avec le revers de cette tôle pour produire, lors du sertissage, la déformation du rivet et former la tête destinée à fixer la pièce rapportée sur celle à laquelle le rivet est intégré.

Dans le cas où l'un des buts de l'invention est de conserver intacte la face de la tôle ou de la plaque formant le revers par rapport au rivet, la réduction locale de l'épaisseur autour de la base et autour du côté de l'élément d'assemblage et de sertissage définit une zone annulaire située du côté de la pièce duquel fait saillie ledit élément d'assemblage et de sertissage. Ainsi, non seulement la base du rivet est au même niveau que la face correspondant au revers, mais cette face ne porte aucune autre marque visible de la présence d'un rivet de l'autre côté, si ce n'est qu'une rainure circulaire d'une profondeur d'environ 0,2 mm, formée par la nervure de la matrice 1, ainsi qu'un très petit cône dont le diamètre correspond à ∼ 1/10^{e} du diamètre du rivet. Ces marques n'affectent toutefois pas la résistance du rivet lors de son écrasement.

Lorsque le déplacement de matière permettant la constitution de la partie saillante de l'élément d'assemblage et de sertissage provient d'une zone située à la base de cet élément et du côté duquel fait saillie cet élément, c'est-à-dire du côté de la pièce à fixer à l'aide du rivet intégré à la pièce d'assemblage métallique, il peut être utile de prévoir des moyens d'appui entre la périphérie de la zone située à la base de l'élément d'assemblage et de sertissage et la partie saillante du rivet pour éviter que lors du sertissage du rivet sur la pièce à fixer, celle-ci ne se déforme dans la zone annulaire. Ces moyens d'appui peuvent présenter diverses formes, celui d'une portée sur la partie saillante du rivet, des nervures radiales réparties angulairement autour du rivet au niveau du bord de la zone annulaire, ou encore une rondelle. Ces moyens d'appui seront préférentiellement disposés de telle manière à ce que leur face supérieure soit coplanaire à la face adjacente de la pièce portant le rivet intégré. Lors du sertissage du rivet, ces moyens d'appui permettent d'éviter la déformation de la pièce sur laquelle la tête du rivet est formée pour la fixer sur l'autre pièce.

Pour faciliter la formation du rivet par fluage au cours d'une opération de pressage à froid, la zone annulaire est inclinée de la base du rivet à la périphérie de cette zone annulaire. Cette inclinaison permet de créer, lors du mouvement de la presse dans l'axe du rivet, une composante de force centripète sur la matière, dirigeant ainsi la matière de la tôle ou de la plaque vers le centre où se trouve l'empreinte de formation de la partie saillante du rivet.

L'invention sera mieux comprise à l'étude de modes de réalisation pris à titre nullement limitatif et illustrés dans les figures annexées dans lesquelles :
- la figure 1 est une vue schématique en coupe axiale d'un mode de réalisation du rivet intégré à l'une des pièces du dispositif de fixation selon l'invention,
- la figure 2 est une vue schématique en coupe axiale du rivet obtenu par le mode de réalisation illustré par la figure 1,
- les figures 3 à 11 sont des vues en coupe axiale de neuf variantes du dispositif de fixation selon l'invention, avant sertissage du rivet.
- La figure 12 est une application de la présente invention à un fond chauffant de bouilloire.

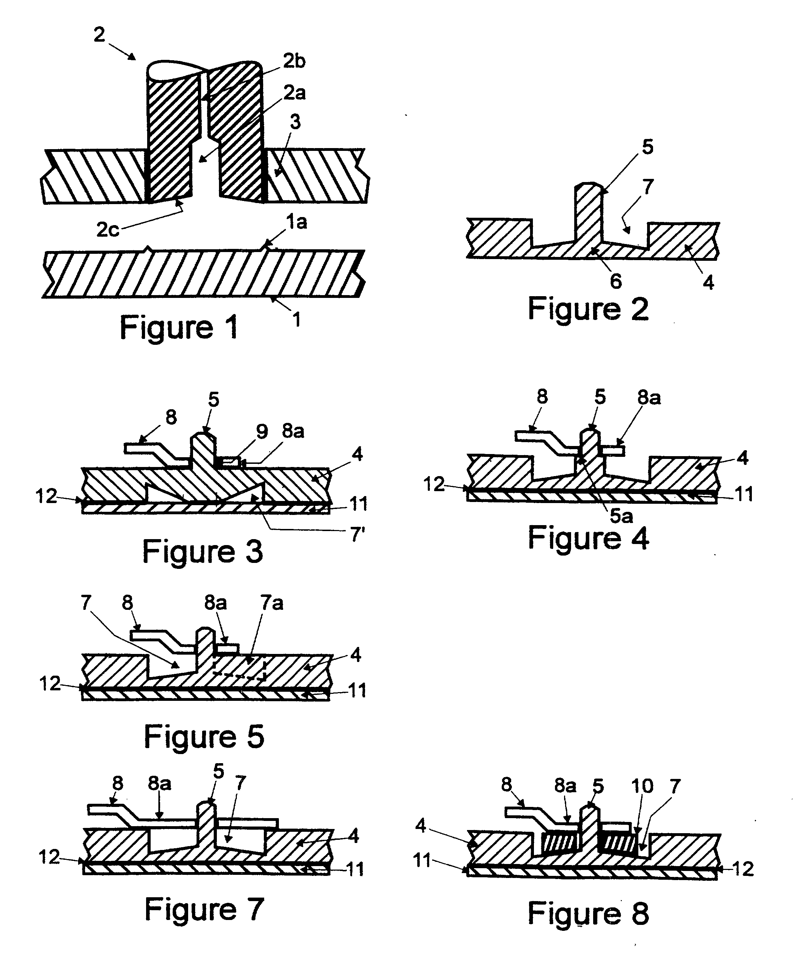

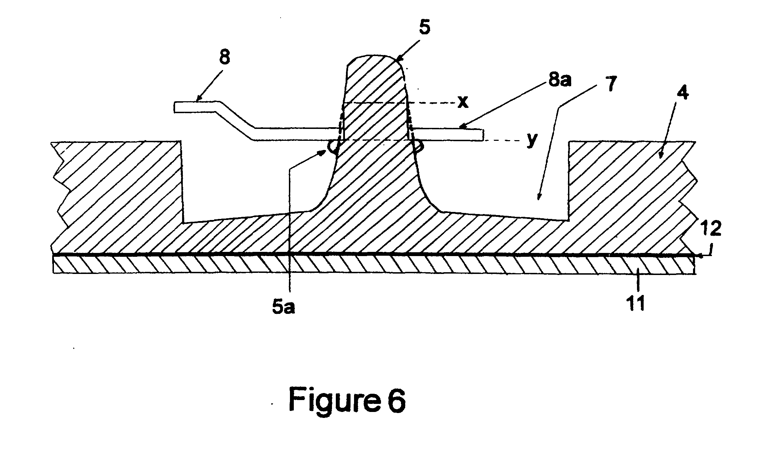

La figure 1 illustre l'outillage utilisé pour réaliser, par déformation à froid, un rivet intégré à partir d'une tôle, dans cet exemple, à partir d'une tôle d'aluminium, destinée au dispositif de fixation objet de la présente invention. Cet outillage comporte une matrice 1, un poinçon 2, et un serre-flan 3. La matrice 1 présente une nervure annulaire 1a de retenue de la matière de la tôle à déformer à froid, dont le diamètre est très légèrement supérieur à celui du poinçon 2. Celui-ci présente une empreinte cylindrique 2a, destinée à former l'élément d'assemblage et de sertissage du rivet, dont le sommet communique avec un trou d'évent 2b. La base du poinçon présente la forme d'un cône 2c qui, dans cet exemple forme un angle au sommet de 156°. Le diamètre de l'empreinte cylindrique 2a, dans cet exemple est de 2,5 mm, celui du poinçon est de 8 mm et les diamètres intérieur et extérieur de la nervure annulaire sont respectivement de 9 et 10 mm.

Dans cet exemple, la tôle d'aluminium 4 (fig. 2) utilisée pour former la pièce d'assemblage métallique dans laquelle est obtenu un rivet intégré par déformation à froid, est une tôle d'aluminium série 1200 de 1,5 mm d'épaisseur. Le rivet ainsi formé comporte un élément d'assemblage et de sertissage 5 dont la base 6 se trouve dans un renfoncement annulaire 7, consécutif au refoulement de la matière de la tôle 4 dans l'élément d'assemblage et de sertissage 5, et s'étend jusqu'au niveau de la face de la tôle 4 opposée à celle de laquelle l'élément d'assemblage et de sertissage 5 fait saillie. Dans cet exemple, la hauteur de l'élément d'assemblage et de sertissage 5 au-dessus de la face supérieure de la tôle 4 est de 2 à 4 mm.

La presse utilisée pour réaliser ce rivet intégré est une presse à vilebrequin. La force exercée sur le poinçon 2 est de 7.10⁴ N et celle exercée sur le serre-flan est de 10⁴ N. De préférence on utilisera également un lubrifiant adéquat pour cette opération de pressage et on réalisera le poinçon 2 en un matériau dur dont les surfaces de travail sont polies miroir. Le serre-flan 3, la nervure annulaire 1a et la face conique 2c sont toutes des mesures prises pour diriger la matière de la tôle 4 dans l'empreinte 2a, en vue de permettre la formation de l'élément d'assemblage et de sertissage 5 du rivet le plus haut possible.

Selon la géométrie des pièces à assembler et leur environnement, différents aménagements peuvent être réalisés tels que ceux illustrés par les figures 3 à 8.

L'exemple illustré par la figure 3, montre une variante selon laquelle le renfoncement de refoulement 7 pour la formation de l'élément d'assemblage et de sertissage 5 se situe sur la face de la tôle 4 opposée à celle de laquelle fait saillie cet élément d'assemblage et de sertissage 5. Une configuration annulaire de ce renfoncement de refoulement 7 garde la base 6 jusqu'au niveau de la face de la tôle 4 opposée à celle de laquelle l'élément d'assemblage et de sertissage fait saillie. La pièce à fixer 8 est alors positionnée par un trou 9 sur cet élément d'assemblage et de sertissage 5. Avec cette disposition, la pièce à fixer 8 ne risque pas de se déformer dans le renfoncement 7 lors du sertissage.

La variante illustrée par la figure 4 permet d'atteindre le même résultat en ménageant une portée 5a située à la base de l'élément d'assemblage et de sertissage 5 du rivet, au niveau de la face supérieure de la pièce d'assemblage métallique 4. Cette portée 5a est obtenue par la forme correspondante de l'empreinte 2a (fig. 1) ménagée dans le poinçon 2. La pièce à fixer 8 est ainsi retenue par la portée 5a qui l'empêche de s'affaisser dans le renfoncement de refoulement 7, de sorte qu'une fois que la tête du rivet est formée par sertissage de la partie de l'élément d'assemblage et de sertissage 5 située au-delà de la pièce à fixer 8, cette pièce 8 est retenue entre cette tête de rivet et la portée 5a.

Selon la variante de la figure 5, des nervures radiales 7a coplanaires à la face supérieure de la tôle 4, par exemple, au nombre de trois, sont réparties angulairement dans le renfoncement de refoulement 7. Comme précédemment, ces nervures empêchent la pièce à fixer 8 de s'affaisser dans le renfoncement 7 au cours du sertissage de l'élément d'assemblage et de sertissage 5.

Au lieu de former la portée 5a illustrée par la variante de la figure 4 par la forme de l'empreinte 2a du poinçon 2, il est possible d'obtenir une butée 5a (fig. 6) par recalibrage de l'élément d'assemblage et de sertissage 5 après la formation par déformation à froid de cet élément. En effet, en adoptant une forme sensiblement cônique du fût de l'élément de sertissage 5, lors de l'assemblage de l'élément 8, un copeau adhérent est généré entre les positions x et y, réalisant ainsi un calibrage et une butée. Il est nécessaire, pour cette réalisation, que le diamètre du trou de 8 soit compris dans les différents diamètres présentés par l'élément 5. Dans le cas de la figure 6, le diamètre de 5 est supérieur au diamètre du trou de 8 entre la position x et la base de cet élément 5, afin de pouvoir générer un tel copeau.

Jusqu'ici, les variantes des figures 3 à 6 permettaient la fixation de pièces 8 dont la portion de surface plate 8a autour du trou 9 engagé sur l'élément d'assemblage et de sertissage 5, était plus petite que la surface du renfoncement annulaire 7, de sorte que cette portion de surface ne pouvait pas être maintenue au niveau de la face supérieure de la tôle 4 sans reposer sur une butée ou autre élément de retenue approprié.

Dans la variante illustrée par la figure 7, on a montré que ce problème peut être résolu lorsque cette portion de surface plate 8a entourant le trou 9 engagé sur l'élément d'assemblage et de sertissage 5 présente une surface plus grande que celle du renfoncement annulaire 7, de sorte que cette surface plate 8a peut s'appuyer contre le bord du renfoncement 7. Il existe dans cette variante un risque de refouler le rivet sous la tôle 8a. Bien que l'épaisseur de la tôle d'acier supporte un appui en périphérie de l'évidement sans déformation préjudiciable, rien n'empêche, même dans ce cas, d'utiliser également une des variantes des figures 4 à 6 pour renforcer la base du rivet et empêcher ce refoulement.

Enfin, à titre d'autre variante des figures 4 à 6 en particulier, également susceptible d'être combinée avec la variante précédente, on peut simplement placer dans le renfoncement annulaire 7 une rondelle 10 dont la face inférieure présente une conicité correspondant à celle du fond du renfoncement 7 et dont la face supérieure est coplanaire à celle de la tôle 4.

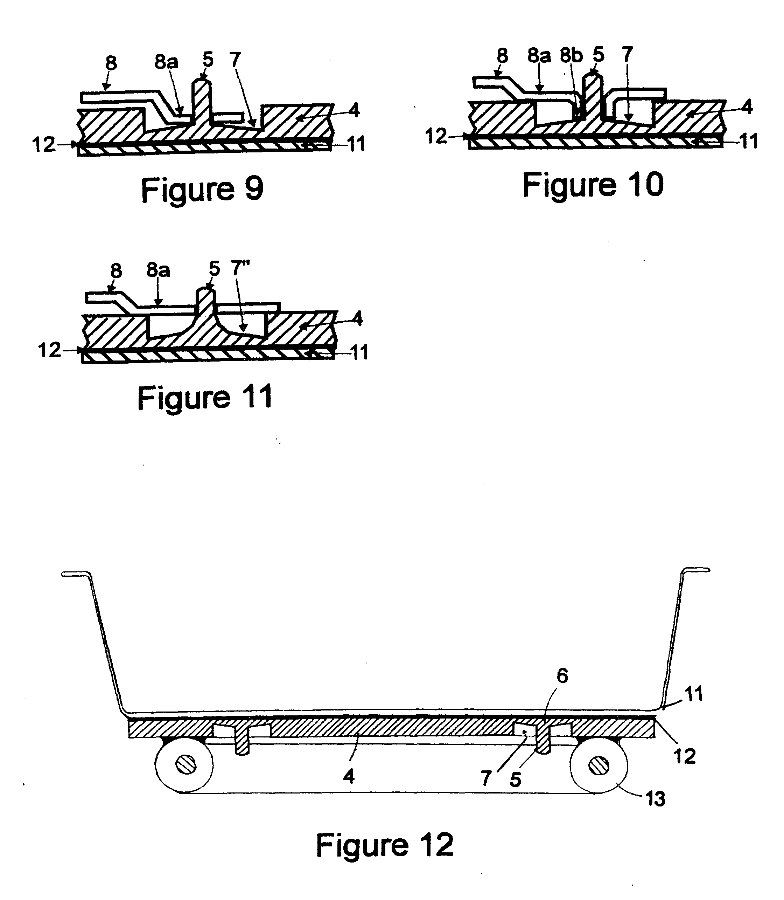

Les variantes illustrées par les figures 9 à 11 permettent aussi d'éviter le risque du refoulement du rivet sous la portion 8a de la tôle 8. Dans la variante de la figure 9, au lieu de former la partie 8a de plus grand diamètre, comme on l'a proposé dans la variante de la figure 7, on la forme, comme dans les variantes des figures 3 à 6, de sorte qu'elle peut pénétrer dans le renfoncement 7 et venir s'appuyer à la base de l'élément d'assemblage et de sertissage 5, évitant de ce fait tout risque de refoulement sous la portion 8a.

Dans la variante illustrée par la figure 10, l'ouverture de la tôle 8 destinée à s'engager sur l'élément d'assemblage et de sertissage 5 comporte une portion tubulaire 8b dont la longueur axiale correspond à la profondeur de la base de l'élément d'assemblage et de sertissage 5 au-dessous du niveau de la face de la tôle d'aluminium dans laquelle est ménagé le renfoncement 7, de sorte que la portion 8a de la tôle 8 est située au niveau de cette face de la tôle d'aluminium 4. Cette portion tubulaire 8b entourant la base de l'élément d'assemblage et de sertissage 5 évite aussi le risque de son refoulement lors du sertissage.

Enfin, la figure 11 montre que la section de l'élément d'assemblage et de sertissage 5 peut augmenter progressivement au-dessous du niveau du bord du renfoncement 7, évitant aussi, de cette manière, les risques de refoulement.

Parmi d'autres variantes envisagées, il est précisé que la section droite de l'élément d'assemblage et de sertissage 5 n'est pas nécessairement circulaire, mais peut aussi être d'une autre forme, par exemple, carrée, en croix, rectangulaire ou toute autre forme appropriée, lorsque l'on désire notamment positionner angulairement la pièce 8 à fixer.

Comme on peut le voir sur les figures 3 à 8, la face inférieure de la pièce métallique de fixation formée par la tôle d'aluminium 4, est représentée sur ces figures, associée à une tôle d'acier inox 11 fixée par brasage 12. Cette tôle d'acier inox 11 est préférentiellement destinée à former une enceinte d'un bouilleur d'eau à usage alimentaire, par exemple, un fond chauffant de bouilloire. Dans ce but, une résistance électrique est brasée sur la plaque aluminium 4.

La figure 12 présente un tel fond chauffant de bouilloire comprenant une résistance chauffante 13 assemblée sur un disque à forte conductivité thermique 4, tel un disque en aluminium, ledit disque étant lui-même assemblé sous une coupelle 11 formant le fond du récipient d'eau de la bouilloire et caractérisé en ce que le disque 4 comporte un dispositif de fixation tel que décrit dans la présente invention.

Il faut encore signaler que le brasage 12 de la tôle d'acier inox peut aussi servir à renforcer la tôle d'aluminium dans laquelle est formée la pièce d'assemblage 4. On peut craindre, en effet, que la finesse de cette tôle au fond du renfoncement 7 ne compromette la résistance de l'assemblage. Le brasage 12 de la tôle inox, dans cet exemple, de 0,5 mm d'épaisseur permet d'éviter ce risque.

Le dispositif de fixation selon la présente invention est donc utilisable avantageusement, bien que non exclusivement, dans le petit appareillage électroménager. Parmi les exemples d'applications envisagées, on peut mentionner l'assemblage d'un régulateur pour résistance électrique dite "cachée" de bouilloire où plusieurs rivets intégrés du type de celui décrit précédemment et formés sur la pièce d'aluminium 4 assurent l'immobilité du régulateur et en même temps la continuité de masse entre ce régulateur et le diffuseur en aluminium.

Ce dispositif d'assemblage présente l'avantage d'être économique à réaliser, robuste et fiable, même dans le cas de tôles fines et de rivets de petits diamètres. Dans le cas de l'application mentionnée ci-dessus à titre d'exemple, dans laquelle la pièce d'assemblage métallique 4 constitue en même temps un diffuseur de chaleur, l'aluminium est particulièrement indiqué en raison de sa bonne déformabilité et de sa bonne conductivité thermique. Suivant les applications envisagées, on peut évidemment choisir d'autres métaux que l'aluminium.

Un autre avantage important de ce dispositif d'assemblage réside dans le fait que le rivet ainsi réalisé ne présente aucun risque de fissure contrairement aux rivets susmentionnés obtenus par déformation de l'art antérieur. Il forme ainsi une barrière parfaitement étanche entre la face brasée sur la tôle d'acier 11 et la face sur laquelle la pièce rapportée 8 est fixée. De ce fait, on évite tout risque de laisser remonter par capillarité du flux de brasage provenant de la brasure 12, qui formerait un résidu solide quasiment incompressible sous l'effort de sertissage, modifiant ainsi la cote d'assemblage. Par ailleurs, dans le cas d'un bouilleur thermorégulé par un bilame, le flux de brasage qui remonterait par capillarité sur l'autre face de la tôle 4 peut aussi perturber le bilame qui pose sur la tôle 4 servant de diffuseur de chaleur, entre les dispositifs de fixation.

## Revendications

1. Dispositif de fixation de pièces d'un appareil électroménager, dont l'une au moins est une pièce d'assemblage métallique (4) en forme de tôle ou de plaque comprenant un élément d'assemblage et de sertissage (5), faisant saillie de l'une des faces de la pièce d'assemblage métallique (4) et dont la structure est issue de ladite pièce, **caractérisé en ce que** la partie de la pièce d'assemblage métallique (4) formant la base (6) dudit élément d'assemblage et de sertissage (5) s'étend jusqu'au niveau de l'autre face de la pièce d'assemblage métallique (4), le volume de la partie saillante dudit élément d'assemblage et de sertissage (5) correspondant sensiblement à celui d'un déplacement de matière (7), obtenu par réduction locale de l'épaisseur autour de la base et autour du côté de l'élément d'assemblage et de sertissage (5).

2. Dispositif selon la revendication 1, **caractérisé en ce que** la réduction locale de l'épaisseur autour de la base (6) et autour du côté de l'élément d'assemblage et de sertissage (5) définit une zone annulaire située du côté de ladite pièce d'assemblage métallique (4) duquel fait saillie ledit élément d'assemblage et de sertissage (5).

3. Dispositif selon la revendication 1, **caractérisé en ce que** la réduction locale de l'épaisseur autour de la base de l'élément d'assemblage et de sertissage (5) définit une zone annulaire (7) située du côté de la pièce d'assemblage métallique (4) opposé à celui duquel fait saillie ledit élément d'assemblage et de sertissage (5).

4. Dispositif selon l'une des revendications 1 et 2, **caractérisé en ce qu'**une portée (5a) est ménagée autour dudit élément d'assemblage et de sertissage (5), au niveau de la face de ladite pièce d'assemblage métallique (4) de laquelle fait saillie ledit élément d'assemblage et de sertissage (5).

5. Dispositif selon la revendication 2, **caractérisé en ce que** des nervures radiales (7a) situées au niveau de la face de la pièce d'assemblage métallique (4) de laquelle fait saillie ledit élément d'assemblage et de sertissage (5), s'étendent à travers ladite zone annulaire (7).

6. Dispositif selon la revendication 2, **caractérisé en ce qu'**un élément annulaire (10) est disposé dans ladite zone annulaire (7) et comporte une face coplanaire à la face adjacente de ladite pièce d'assemblage métallique (4).

7. Dispositif selon l'une des revendications 2 à 6, **caractérisé en ce que** le fond de ladite zone annulaire (7) est incliné en direction de ladite autre face de ladite pièce d'assemblage métallique (4), de la base (6) dudit élément d'assemblage et de sertissage (5) à la périphérie de ladite zone annulaire (7).

8. Dispositif selon l'une des revendications précédentes, **caractérisé en ce que** la section droite dudit élément d'assemblage et de sertissage (5) est non circulaire et conformée pour permettre de donner une orientation angulaire à la pièce assemblée (8).

9. Dispositif selon l'une des revendications précédentes, **caractérisé en ce que** ledit élément d'assemblage métallique (4) est en aluminium.

10. Dispositif selon l'une des revendications précédentes, **caractérisé en ce que** la face dudit élément d'assemblage métallique (4) opposée à celle de laquelle fait saillie ledit élément d'assemblage et de sertissage (5) est brasée à une feuille d'acier inoxydable (11).

11. Fond chauffant de bouilloire comprenant une résistance chauffante (13) assemblée sur un disque à forte conductivité thermique (4), ledit disque étant lui-même assemblé sous une coupelle (11) formant le fond du récipient d'eau de la bouilloire, **caractérisé en ce que** le disque (4) comporte un dispositif de fixation conforme à l'une des revendications 1 à 10.

## Patentansprüche

1. Vorrichtung zur Befestigung von Stücken eines Elektrohaushaltsgeräts, von welchen zumindest eines ein Metallstück (4) zum Zusammenfügen in Form eines Blechs oder einer Platte mit einem Element (5) zum Zusammenfügen und Verstemmen ist, welches von einer der Flächen des Metallstücks (4) zum Zusammenfügen hervorsteht und dessen Struktur von dem Stück stammt, **dadurch gekennzeichnet, daß** sich der Teil des Metallstücks (4) zum Zusammenfügen, der die Basis (6) des Elements (5) zum Zusammenfügen und Verstemmen bildet, bis zur Höhe der anderen Fläche des Metallstücks (4) zum Zusammenfügen erstreckt, wobei das Volumen des vorstehenden Teils des Elements (5) zum Zusammenfügen und Verstemmen im wesentlichen jenem einer Materialverdrängung (7) entspricht, die durch lokale Verringerung der Dicke um die Basis und um die Seite des Elements (5) zum Zusammenfügen und Verstemmen erhalten wird.

2. Vorrichtung nach Anspruch 1, **dadurch gekennzeichnet, daß** die lokale Verringerung der Dicke um die Basis (6) und um die Seite des Elements (5) zum Zusammenfügen und Verstemmen eine ringförmige Zone definiert, die auf derjenigen Seite des Metallstücks (4) zum Zusammenfügen angeordnet ist, von welcher das Element (5) zum Zusammenfügen und Verstemmen vorsteht.

3. Vorrichtung nach Anspruch 1, **dadurch gekennzeichnet, daß** die lokale Verringerung der Dicke um die Basis des Elements (5) zum Zusammenfügen und Verstemmen eine ringförmige Zone (7) definiert, die auf der Seite des Metallstücks (4) zum Zusammenfügen entgegengesetzt zu jener, von welcher das Element (5) zum Zusammenfügen und Verstemmen vorsteht, angeordnet ist.

4. Vorrichtung nach einem der Ansprüche 1 und 2, **dadurch gekennzeichnet, daß** eine Lagerfläche (5a) um das Element (5) zum Zusammenfügen und Verstemmen auf der Höhe der Fläche des Metallstücks (4) zum Zusammenfügen ausgebildet ist, von welcher das Element (5) zum Zusammenfügen und Verstemmen vorsteht.

5. Vorrichtung nach Anspruch 2, **dadurch gekennzeichnet, daß** radiale Rippen (7a), die auf der Höhe der Fläche des Metallstücks (4) zum Zusammenfügen angeordnet sind, von welcher das Element (5) zum Zusammenfügen und Verstemmen vorsteht, sich durch die ringförmige Zone (7) erstrecken.

6. Vorrichtung nach Anspruch 2, **dadurch gekennzeichnet, daß** ein ringförmiges Element (10) in der ringförmigen Zone (7) angeordnet ist und eine Fläche aufweist, die zur benachbarten Fläche des Metallstücks (4) zum Zusammenfügen koplanar ist.

7. Vorrichtung nach einem der Ansprüche 2 bis 6, **dadurch gekennzeichnet, daß** der Boden der ringförmigen Zone (7) in der Richtung der anderen Fläche des Metallstücks (4) zum Zusammenfügen von der Basis (6) des Elements (5) zum Zusammenfügen und Verstemmen zum Umfang der ringförmigen Zone (7) geneigt ist.

8. Vorrichtung nach einem der vorangehenden Ansprüche, **dadurch gekennzeichnet, daß** der gerade Querschnitt des Elements (5) zum Zusammenfügen und Verstemmen nicht-kreisförmig ist und angepaßt ist, um zu ermöglichen, dem angefügten Stück (8) eine Winkelorientierung zu verleihen.

9. Vorrichtung nach einem der vorangehenden Ansprüche, **dadurch gekennzeichnet, daß** das Metallelement (4) zum Zusammenfügen aus Aluminium besteht.

10. Vorrichtung nach einem der vorangehenden Ansprüche, **dadurch gekennzeichnet, daß** die Fläche des Metallelements (4) zum Zusammenfügen entgegengesetzt zu jener, von der das Element (5) zum Zusammenfügen und Verstemmen vorsteht, an eine Tafel (11) aus rostfreiem Stahl gelötet ist.

11. Heizboden für einen Wasserkocher mit einem Heizwiderstand (13), der mit einer Scheibe (4) mit hoher Wärmeleitfähigkeit zusammengefügt ist, wobei die Scheibe wiederum unter eine Schale (11) angefügt ist, die den Boden des Wasserbehälters des Wasserkochers bildet, **dadurch gekennzeichnet, daß** die Scheibe (4) eine Befestigungsvorrichtung nach einem der Ansprüche 1 bis 10 aufweist.

## Claims

1. A device for fixing parts of an electrical household appliance, in which at least one of the parts is a metal assembly part (4) in sheet or plate form including an assembly and crimping element (5) projecting from one of the faces of the metal assembly part (4) and of a structure that is formed integrally with said part, the device being **characterized in that** the metal assembly part (4) forming the base (6) of said assembly and crimping element (5) extends to the other face of the metal assembly part (4), the volume of the projecting portion of said assembly and crimping element (5) corresponding substantially to that of the volume of displaced material (7) obtained by locally reducing thickness around the base and around the side of the assembly and crimping element (5).

2. A device according to claim 1, **characterized in that** the local reduction in thickness around the base (6) and around the side of the assembly crimping element (5) defines an annular zone situated on the same side of said metal assembly part (4) as the side from which said assembly and crimping element (5) projects.

3. A device according to claim 1, **characterized in that** the local reduction in thickness around the base of the assembly crimping element (5) defines an annular zone (7) situated on the side of the metal assembly part (4) opposite from the side from which said assembly crimping element (5) projects.

4. A device according to claim 1 or claim 2, **characterized in that** a bearing surface (5a) is provided around said assembly and crimping element (5) in the face of said metal assembly part (4) from which said assembly and crimping element (5) projects.

5. A device according to claim 2, **characterized in that** radial ribs (7a) situated on the face of the metal assembly part (4) from which said assembly and crimping element (5) projects extend through said annular zone (7).

6. A device according to claim 2, **characterized in that** an annular element (10) is disposed in said annular zone (7) and has a face coplanar with the adjacent face of said metal assembly part (4).

7. A device according to any one of claims 2 to 6, **characterized in that** the bottom of said annular zone (7) slopes towards said other face of said metal assembly part (4), from the base (6) of said assembly and crimping part (5) towards the periphery of said annular zone (7).

8. A device according to any preceding claim, **characterized in that** the right section of said assembly and crimping element (5) is non-circular and shaped to enable an angular orientation to be given to the assembly part (8).

9. A device according to any preceding claim, **characterized in that** said metal assembly element (4) is made of aluminum.

10. A device according to any preceding claim, **characterized in that** the face of said metal assembly element (4) remote from the face from which said assembly and crimping element (5) projects is brazed to a sheet of stainless steel (11).

11. A heating bottom for a kettle, the bottom comprising a heating resistance (13) assembled on a disk (4) having high thermal conductivity, said disk itself being assembled beneath a cup (11) forming the bottom of the water receptacle of the kettle, the heating bottom being **characterized in that** the disk (4) includes a fixing device according to any one of claims 1 to 10.
